(19) Europäisches Patentamt
European Patent Office
Office européen des brevets

(11) **EP 3 886 189 B1**

(12) **EUROPÄISCHE PATENTSCHRIFT**

(45) Veröffentlichungstag und Bekanntmachung des Hinweises auf die Patenterteilung:
**06.07.2022   Patentblatt 2022/27**

(21) Anmeldenummer: **20165725.1**

(22) Anmeldetag: **25.03.2020**

(51) Internationale Patentklassifikation (IPC):
**H01L 41/04** (2006.01)      **H02N 2/06** (2006.01)
**H02N 2/14** (2006.01)

(52) Gemeinsame Patentklassifikation (CPC):
**H02N 2/062; H01L 41/042; H02N 2/142**

(54) **STEUERN EINES ANTRIEBS MIT PERIODISCHEM UNGLEICHLAUF**

CONTROL OF A DRIVE WITH PERIODIC IRREGULARITY

COMMANDE D'UN ENTRAÎNEMENT À FONCTIONNEMENT ASYNCHRONE PÉRIODIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**29.09.2021   Patentblatt 2021/39**

(73) Patentinhaber: **Airbus Defence and Space GmbH 82024 Taufkirchen (DE)**

(72) Erfinder:
• **Sell, Alexander**
  **82024 Taufkirchen (DE)**
• **Brugger, Christina**
  **82024 Taufkirchen (DE)**
• **Pfeiffer, Katja**
  **82024 Taufkirchen (DE)**
• **Mandel, Oliver**
  **82024 Taufkirchen (DE)**

(74) Vertreter: **LKGLOBAL**
**Lorenz & Kopf PartG mbB Patentanwälte**
**Brienner Straße 11**
**80333 München (DE)**

(56) Entgegenhaltungen:
**EP-A1- 1 737 114          EP-B1- 2 209 202**
**WO-A1-91/17351          DE-A1-102007 016 642**
**US-A1- 2012 019 185**

**Beschreibung**

TECHNISCHES GEBIET

Die Beschreibung betrifft ein Verfahren zum Steuern eines Antriebs mit einem Aktuator mit periodischem Ungleichlauf sowie eine Steuereinheit, welche ausgeführt ist, einen Antrieb mit einem Aktuator mit periodischem Ungleichlauf zu steuern.

HINTERGRUND

Antriebe weisen in der Regel eine bewegungserzeugende Einheit auf, welche als Aktuator bezeichnet werden kann. In dem Aktuator wird typischerweise die Bewegung einer oder mehrerer Aktuatoreinheiten in eine Antriebsbewegung eines Antriebselements umgesetzt. Die Bewegung des Antriebselements kann dann genutzt werden, um einen gewünschten Effekt hervorzurufen.

Zahlreiche Antriebe funktionieren über interne periodische Bewegungsabläufe. Dies gilt insbesondere für elektrische Antriebe. Ausgewählte Beispiele für elektrische Antriebe sind Piezo-Friktionsantriebe sowie Motorspindelantriebe.

Alle diese Antriebe weisen mindestens eine Aktuatoreinheit auf, welche mittels Zufuhr von Energie eine Bewegung erzeugt. Typischerweise führt die Aktuatoreinheit eine periodische Bewegung aus, welche beispielsweise mittels Stangen und Gelenken auf ein bewegungsübertragendes Element (ein Antriebselement) übertragen wird.

Die periodischen Bewegungen der Aktuatoreinheiten können zu einem periodischen Ungleichlauf des Antriebselements führen.

Antriebe auf Basis von Piezo-Elementen sind bekannt und beispielsweise beschrieben in EP 1 267 478 B1.

Ein Verfahren zum Betreiben eines Piezo-Linearantriebs mit einer Gruppe von Piezo-Stapelaktuatoren ist beschreiben in EP 2 209 202 B1.

Ansteuerverfahren unter Verwendung von Rückkopplungssignalen sind unter anderem aus EP 1 737 113 und US 2012/0019185 A1 bekannt.

BESCHREIBUNG DER ERFINDUNG

Es kann als Aufgabe betrachtet werden, einen Antrieb mit einem Aktuator mit periodischem Ungleichlauf so anzusteuern, dass die Wirkung des periodischen Ungleichlaufs auf ein angetriebenes Element reduziert oder eliminiert wird.

Diese Aufgabe wird gelöst mit dem Gegenstand der unabhängigen Ansprüche. Weiterbildungen ergeben sich aus den abhängigen Ansprüchen und der folgenden Beschreibung.

Gemäß einem ersten Aspekt ist ein Verfahren zum Steuern eines Antriebs mit einem Aktuator mit periodischem Ungleichlauf angegeben. Das Verfahren weist die folgenden Schritte auf: Empfangen eines Bewegungsmusters des Antriebs, wobei das Bewegungsmuster eine ausgeführte Bewegung und ein zugehöriges Ansteuersignal des Antriebs aufweist; Ermitteln einer Bewegungsfunktion des Antriebs basierend auf dem Bewegungsmuster, wobei die Bewegungsfunktion die ausgeführte Bewegung über dem zugehörigen Ansteuersignal darstellt; Invertieren der Bewegungsfunktion des Antriebs, um eine invertierte Bewegungsfunktion zu erhalten, wobei die invertierte Bewegungsfunktion das Ansteuersignal über der ausgeführten Bewegung darstellt; und Ansteuern des Antriebs gemäß der invertierten Bewegungsfunktion, wobei ein Ansteuersignal zum Ausführen einer vorgegebenen Bewegung aus der invertierten Bewegungsfunktion entnommen wird.

Als Antrieb wird vorliegend ein gesamtes System bezeichnet, welchem Energie zugeführt wird und welches eine Bewegung liefert. Der Aktuator ist Teil des Antriebs und im Wesentlichen ausgestaltet, die zugeführte Energie in eine Bewegung umzuwandeln. Der Antrieb kann beispielsweise als Linearantrieb oder Rotationsantrieb ausgestaltet sein, wobei ein Linearantrieb eine lineare oder translatorische Bewegung liefert, wohingegen ein Rotationsantrieb eine rotatorische Bewegung liefert.

Der Aktuator weist typischerweise eine oder mehrere Aktuatoreinheiten auf, welche aus der zugeführten Energie eine Antriebsleistung oder Bewegung erzeugen und abgeben. Jede Aktuatoreinheit kann ein oder mehrere Aktuatorelemente aufweisen.

Die Aktuatorelemente, und damit jede Aktuatoreinheit, führen periodische Bewegungen aus. D.h., selbst wenn ein Linearantrieb als solcher keine periodische Bewegung ausführt, z.B. weil eine Welle zwischen einer ersten Position und einer zweiten Position linear verschoben wird, so führen die Aktuatorelemente dennoch eine periodische Bewegung aus.

Das Bewegungsmuster enthält Informationen über eine ausgeführte Bewegung in Abhängigkeit von einem Ansteuersignal des Antriebs. Bei diesen Informationen kann es sich beispielsweise um eine relative Positionsangabe (Positionsänderung) oder absolute Positionsangabe oder um eine relative Geschwindigkeitsangabe (Geschwindigkeitsänderung) oder absolute Geschwindigkeitsangabe handeln. Die ausgeführte Bewegung bezieht sich dabei auf ein Antriebselement des Antriebs, welches die gewünschte Bewegung an eine anzutreibende Vorrichtung überträgt. Die ausgeführte Bewegung kann zusätzlich oder alternativ auch einen relativen oder absoluten Beschleunigungswert enthalten, sofern die Dynamik des Antriebs keine relevante Rolle spielt.

Das Bewegungsmuster des Antriebs kann beispielsweise durch einen Messvorgang direkt an dem Antrieb erfasst und zusammen mit dem zugehörigen Ansteuersignal für das weitere Verfahren zur Verfügung gestellt werden. Das Bewegungsmuster kann aber auch aus einer Datei ausgelesen werden, welche Informationen über einen Messvorgang aus der Vergangenheit enthält.

Die Bewegungsfunktion des Antriebs wird beispielsweise ermittelt, indem die Bewegung des Antriebselements über dem zugehörigen Ansteuersignal in einen Graphen eingetragen wird.

Sodann wird die Bewegungsfunktion invertiert. Die invertierte Bewegungsfunktion wird als Grundlage für das Ermitteln eines Ansteuersignals für eine gewünschte oder vorgegebene Bewegung (z.B. Position, Geschwindigkeit, oder Beschleunigung) verwendet. Indem der Antrieb gemäß dem Ansteuersignal der invertierten Bewegungsfunktion angesteuert wird, bewegt sich das Antriebselement gleichmäßig, obwohl die Aktuatoreinheit einen periodischen Ungleichlauf hat.

Der periodische Ungleichlauf der Aktuatoreinheit wird also dahingehend berücksichtigt, dass ein Ansteuersignal so gestaltet wird, dass der periodische Ungleichlauf der Aktuatoreinheit durch das modifizierte Ansteuersignal (entsprechend der invertierten Bewegungsfunktion) in einer gleichmäßigen (linearen oder rotatorischen) Bewegung des Antriebselements des Antriebs resultiert.

Das Verfahren eignet sich dazu, den periodischen Ungleichlauf eines Aktuators durch geeignete Ansteuerung dieses Aktuators sowohl im gestellten Betrieb (ohne verfügbare Messgröße über die tatsächlich ausgeführte Bewegung des Antriebselements) als auch im geregelten Betrieb (mit Erfassung der ausgeführten Bewegung des Antriebselements) zu reduzieren.

Das Verfahren ist vorteilhaft anwendbar auf ein- oder mehrphasige Aktuatoren, d.h. auf Aktuatoren mit einem oder mehreren Aktuatorelementen, sofern die Aktuatorelemente einzeln angesteuert und die resultierenden Bewegungen des Antriebselements gemessen werden können. Das Verfahren ist weiter vorteilhaft anwendbar, sofern der Bewegungsablauf der Aktuatorelemente für verschiedene Geschwindigkeiten des Antriebselements im Wesentlichen unverändert bleibt.

Gemäß einer Ausführungsform weist das Verfahren weiterhin folgende Schritte auf: Ansteuern des Antriebs mit einem zeitabhängigen Ansteuersignal über mindestens eine Aktuatorperiode; Erfassen einer von dem Antrieb ausgeführten Bewegung in Abhängigkeit von dem zeitabhängigen Ansteuersignal; Erstellen des Bewegungsmusters des Antriebs basierend auf dem zeitabhängigen Ansteuersignal und der ausgeführten Bewegung.

Diese Ausführungsform beschreibt ein Beispiel, wie das Bewegungsmuster des Antriebs erfasst werden kann. Zum Erfassen der Bewegung können geeignete Sensoren (z.B. Positions- , Geschwindigkeits-, oder Beschleunigungssensoren) an dem Antriebselement des Aktuators angeordnet werden.

Alternativ zu diesem Beispiel kann die Bewegung des Antriebselements aus einer Tabelle entnommen werden, welche die Bewegung des Antriebselements über einem Ansteuersignal enthält.

Gemäß einer weiteren Ausführungsform wird die von dem Antrieb in Abhängigkeit von dem zeitabhängigen Ansteuersignal ausgeführte Bewegung zu äquidistanten diskreten Werten des Ansteuersignals und mehrfach für jede Aktuatorperiode erfasst.

Somit kann ein periodischer Ungleichlauf des Aktuators vorteilhaft erfasst werden, weil der Aktuator diesen Ungleichlauf in jeder Periode aufzeigt.

Gemäß einer weiteren Ausführungsform enthält das Erfassen einer von dem Antrieb ausgeführten Bewegung das Erfassen einer von dem Antrieb angefahrenen Position, wobei für die angefahrene Position zu jedem diskreten Messpunkt eine Differenz zu der angefahrenen Position des unmittelbar vorangegangenen Messpunktes ermittelt wird, wobei die ermittelte Differenz für die Gesamtheit der Messpunkte einer numerischen Ableitung der angefahrenen Position nach dem Ansteuersignal entspricht.

Hiermit wird das lineare Anwachsen des erfassten Wertes mit dem Ansteuersignal vermieden, weil lediglich die Differenz zu dem vorangegangen erfassten Wert verarbeitet wird. Dieser Vorgang entspricht einer numerischen Ableitung der Positionsveränderung.

Gemäß einer weiteren Ausführungsform wird die erfasste ausgeführte Bewegung gefiltert, um periodische Anteile von nicht-periodischen Anteilen zu trennen.

Um das korrigierte Ansteuersignal für den periodischen Antrieb zu ermitteln, ist lediglich der durch den Antrieb eingebrachte periodische Ungleichlauf relevant, nicht-periodische Anteile werden an dieser Stelle vernachlässigt bzw. unterdrückt.

Ein Filteralgorithmus kann angewandt werden auf einen Signalverlauf, welcher der erfassten ausgeführten Bewegung entspricht. Wenn von der ausgeführten Bewegung ein Geschwindigkeitswert erfasst wird, kann dieser Geschwindigkeitswert gefiltert werden. Wenn die angefahrene Position des Antriebs erfasst wird, dann wird der Filteralgorithmus auf die numerische Ableitung der angefahrenen Position angewandt.

Gemäß einer weiteren Ausführungsform wird die erfasste ausgeführte Bewegung gefiltert, indem die erfasste ausgeführte Bewegung einer Fourier-Transformation unterzogen wird, zugehörige Fourier-Koeffizienten bestimmt werden, und basierend auf den bestimmten Fourier-Koeffizienten eine Fourier-Rücktransformation erfolgt.

Beispielsweise werden Fourier-Koeffizienten bei ganzzahligen Vielfachen einer Grundfrequenz, die einer Antriebsperiodizität bestimmt, wobei die Antriebsperiodizität einer Periode der Aktuatoreinheiten entspricht. Die Aktuatoreinheiten führen periodische Bewegungen bzw. Vorgänge aus. Somit geht es bei den Fourier-Koeffizienten darum, die internen periodischen Vorgänge abzubilden.

Ein Filteralgorithmus kann angewandt werden auf einen Signalverlauf, welcher der erfassten ausgeführten Bewegung entspricht. Wenn von der ausgeführten Bewegung ein Geschwindigkeitswert erfasst wird, kann dieser Geschwindigkeitswert gefiltert werden. Wenn die angefahrene Position des Antriebs erfasst wird, dann wird der Filteralgorithmus auf die numerische Ableitung der angefahrenen Position angewandt.

Gemäß einer weiteren Ausführungsform wird das Ansteuersignal gemäß der invertierten Bewegungsfunktion zum Ansteuern des Antriebs mit einem zeitabhängigen Ansteuersignal über mindestens eine Aktuatorperiode verwendet.

Das Ansteuersignal gemäß der invertierten Bewegungsfunktion wird also verwendet, um den Antrieb anzusteuern. Sodann wird die aus diesem Ansteuersignal resultierende Bewegung erfasst. Das entsprechende Bewegungsmuster kann dann erneut verwendet werden, um das Ansteuersignal zu invertieren und so in mehrere Schritten das Ansteuersignal zu modifizieren, was zu einer weiteren Reduzierung des periodischen Ungleichlaufs führen kann.

Gemäß einer weiteren Ausführungsform weist der Aktuator eine Mehrzahl von Aktuatoreinheiten auf, wobei jede Aktuatoreinheit mindestens zwei Aktuatorelemente aufweist und wobei als Ansteuersignal ein mehrphasiges Signal mit einer Phase für jedes Aktuatorelement erzeugt wird.

Eine Piezo-Aktuatoreinheit weist typischerweise eine Mehrzahl von Piezo-Elementen auf. Eine Piezo-Aktuatoreinheit ist in der Regel als Paar von zwei miteinander verbundenen Piezo-Elementen ausgestaltet. Die Bewegungen der einzelnen Piezo-Elemente überlagern sich, so dass ein Paar von Piezo-Elementen eine zweidimensionale Bewegung ausführt. Ein Piezo-Element wird von einer Phase angesteuert. Das Ansteuersignal in seiner Gesamtheit besteht aus einer Mehrzahl von Phasen mit jeweils einer Phase für jedes Piezo-Element.

Somit werden die einzelnen Aktuatoreinheiten so bewegt, dass ihre Bewegung in eine Linearbewegung oder Rotationsbewegung des Antriebselements des Antriebs umgesetzt wird.

Gemäß einer weiteren Ausführungsform ist das mehrphasige Signal so ausgestaltet, dass eine periodische Bewegung der Aktuatoreinheiten in einer linearen oder rotatorischen Bewegung eines Antriebselements des Antriebs resultiert.

Gemäß einer weiteren Ausführungsform sind die Aktuatoreinheiten der Mehrzahl von Aktuatoreinheiten in zwei Gruppen unterteilt und jeweils die Aktuatoreinheiten einer Gruppe werden synchron mit gleichen Phasen angesteuert.

Das Verfahren wie hierin beschrieben eignet sich besonders vorteilhaft dafür, Antriebe anzusteuern, bei denen eine periodische Bewegung einer Mehrzahl von Aktuatoreinheiten zu einer Bewegung eines Antriebselements führt. Die Aktuatoreinheiten können durch ihre periodische Bewegung einen Ungleichlauf in das Antriebselement einbringen, welcher über das gemäß den hierin beschriebenen Prinzipien ausgestaltete Ansteuersignal eliminiert wird.

In einem Beispiel werden pro Aktuatoreinheit zwei Phasen verwendet, nämlich eine Phase pro Aktuatorelement.

Gemäß einer weiteren Ausführungsform ist jede Aktuatoreinheit eine Piezo-Einheit mit zumindest zwei Piezo-Elementen, wobei die Piezo-Elemente einer Piezo-Einheit so miteinander verbunden sind, dass die Piezo-Einheit eine zweidimensionale Bewegung ausführen kann, wenn sie mit einem zweiphasigen Ansteuersignal angesteuert wird.

Gemäß einer weiteren Ausführungsform wird zum Erzeugen des Ansteuersignals eine unipolare Spannungsquelle verwendet.

Beispielsweise eignet sich das Verfahren insbesondere dazu, Antriebe an Bord von Satelliten anzusteuern. An Bord von Satelliten werden beispielsweise unipolare Spannungsquellen mit 40 bis 60 Volt verwendet. Das hierin beschriebene Verfahren kann Spannungen aus diesem vergleichsweise niedrigen Spannungsbereich verwenden, um wie beschrieben Antriebe anzusteuern.

Gemäß einer weiteren Ausführungsform wird das Verfahren zum Einstellen einer Position eines rückkopplungsfreien Antriebs verwendet.

Gemäß einem weiteren Aspekt ist eine Steuereinheit zum Steuern eines Antriebs mit einem Aktuator mit periodischem Ungleichlauf angegeben. Die Steuereinheit ist konfiguriert, die folgenden Schritte auszuführen: Empfangen eines Bewegungsmusters des Antriebs, wobei das Bewegungsmuster eine angefahrene Position und ein zugehöriges Ansteuersignal des Antriebs aufweist; Ermitteln einer Bewegungsfunktion des Antriebs basierend auf dem Bewegungsmuster, wobei die Bewegungsfunktion die angefahrene Position über dem zugehörigen Ansteuersignal darstellt; Invertieren der Bewegungsfunktion des Antriebs, um eine invertierte Bewegungsfunktion zu erhalten, wobei die invertierte Bewegungsfunktion das Ansteuersignal über der angefahrenen Position darstellt; Ansteuern des Antriebs gemäß der invertierten Bewegungsfunktion, wobei ein Ansteuersignal zum Anfahren einer vorgegebenen anzufahrenden Position aus der invertierten Bewegungsfunktion entnommen wird.

In anderen Worten ist die Steuereinheit konfiguriert, die Schritte des hierin beschriebenen Verfahrens auszuführen. Die Steuereinheit kann dabei die Schritte einer jeden der hierin beschriebenen Ausführungsformen des Verfahrens ausführen. Merkmale und Schritte, welche mit Bezug zu dem Verfahren beschrieben sind, können auch als funktionale Merkmale der Steuereinheit implementiert werden, auch wenn an dieser Stelle nicht jeder einzelne Schritt des Verfahrens wiederholt wird.

Gemäß einer Ausführungsform ist die Steuereinheit ausgeführt zum Ansteuern des Antriebs mit einem zeitabhängigen Ansteuersignal über mindestens eine Aktuatorperiode; Erfassen einer von dem Antrieb ausgeführten Bewegung in Abhängigkeit von dem zeitabhängigen Ansteuersignal; und Erstellen des Bewegungsmusters des Antriebs basierend auf dem zeitabhängigen Ansteuersignal und der ausgeführten Bewegung.

Die Steuereinheit kann Sensoren aufweisen oder mit Sensoren verbunden sein, welche die von dem Antrieb ausgeführte Bewegung erfassen können.

KURZE BESCHREIBUNG DER FIGUREN

Nachfolgend wird anhand der beigefügten Zeichnungen näher auf Ausführungsbeispiele der Erfindung eingegangen. Die Darstellungen sind schematisch und nicht maßstabsgetreu. Gleiche Bezugszeichen beziehen sich auf gleiche oder ähnliche Elemente. Es zeigen:

Fig. 1 eine schematische Darstellung eines Antriebs;
Fig. 2A eine schematische Darstellung der Aktuatorgeometrie eines Piezo-Antriebs;
Fig. 2B eine schematische Darstellung der Aktuatorgeometrie eines Piezo-Antriebs;
Fig. 2C eine schematische Darstellung der Aktuatorgeometrie eines Piezo-Antriebs;
Fig. 3A eine schematische Darstellung eines mehrphasigen Ansteuersignal;
Fig. 3B eine schematische Darstellung eines modifizierten mehrphasigen Ansteuersignals;
Fig. 4 eine schematische Darstellung eines Bewegungsmusters eines Antriebs;
Fig. 5 eine schematische Darstellung des gefilterten Bewegungsmusters eines Antriebs;
Fig. 6 eine schematische Darstellung einer invertierten Bewegungsfunktion;
Fig. 7 eine schematische Darstellung der Fourier-Koeffizienten des gefilterten Bewegungsmusters aus Fig. 5;
Fig. 8A eine schematische Darstellung einer Steuereinheit zum Steuern eines Antriebs;
Fig. 8B eine schematische Darstellung eines Verstärkers zum Verstärken der Ausgangssignale der Steuereinheit aus Fig. 8A;
Fig. 9 eine schematische Darstellung des Ablaufs eines Verfahrens zum Steuern eines Antriebs.

DETAILLIERTE BESCHREIBUNG VON AUSFÜHRUNGSBEISPIELEN

Die Darstellungen in den Figuren sind schematisch und nicht maßstabsgetreu. Werden in den Figuren gleiche oder ähnliche Bezugszeichen verwendet, so beziehen sich diese auf gleiche oder ähnliche Elemente.

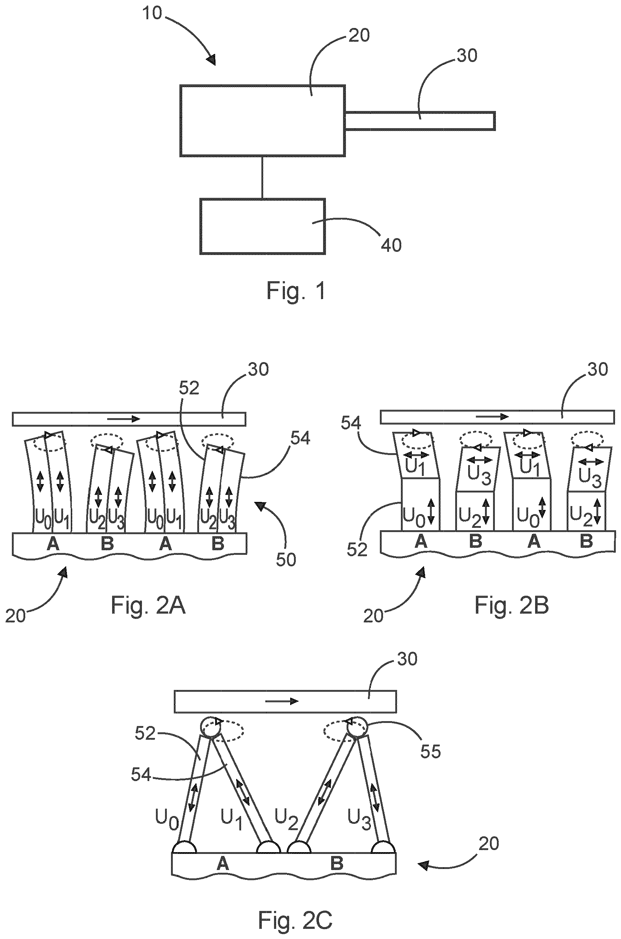

Fig. 1 zeigt schematisch den Aufbau eines Antriebs 10. Der Antrieb besteht aus einem Aktuator 20, welcher ein Antriebselement 30 in Bewegung (linear oder rotatorisch) versetzt. Eine Steuereinheit 40 ist mit dem Antrieb 10 verbunden. Die Steuereinheit 40 kann sowohl Steuerbefehle als auch eine benötigte Antriebsenergie an den Antrieb 10 übermitteln.

Fig. 2A, 2B und 2C zeigen beispielhafte Aktuatorgeometrien für Piezo-Friktionsantriebe, welche beispielhaft als Aktuator 20 verwendet werden können.

Zwei Aktuatorelemente 52, 54 (Piezo-Elemente) bilden zusammen eine Aktuatoreinheit 50. Durch die individuelle Ansteuerung der Aktuatorelemente 52, 54 führt eine Aktuatoreinheit 50 eine zweidimensionale Bewegung aus, welche auf das Antriebselement 30 übertragen wird. Die Aktuatorelemente 52, 54 werden mit zwei Spannungswerten angesteuert.

Die Aktuatoreinheiten 50 sind gruppiert in zwei Gruppen, wobei für die zwei Gruppen die Buchstaben A und B verwendet werden. Die Aktuatoreinheiten innerhalb einer der Gruppen bewegen sich üblicherweise synchron und werden durch identische Ansteuersignale angesteuert.

Fig. 2A zeigt einen Biege-Piezoantrieb, bei welchem die Biegebewegungen der einzelnen Aktuatorelemente 52, 54 genutzt werden, um die zweidimensionale Bewegung der Aktuatoreinheit 50 hervorzurufen. Die Aktuatorelemente 52, 54 werden über eine Phase U2, U3 angesteuert. Dies gilt für alle Aktuatoreinheiten der Gruppe B. Die Aktuatoreinheiten der Gruppe A werden über einen Phase U0, U1 angesteuert. Fig. 2B zeigt einen Klemm-Scher-Piezoantrieb. Hierbei wird eine Auf-Ab-Bewegung des unteren Aktuatorelements 52 mit einer dazu quer verlaufenden Links-Rechts-Bewegung des oberen Aktuatorelements 54 kombiniert.

Fig. 2C zeigt einen Wander-Piezoantrieb, bei dem Veränderungen der Länge der einzelnen Aktuatorelemente 52, 54 verwendet werden, um eine zweidimensionale Bewegung eines Antriebspunktes 55 zu erzeugen.

Der Antriebspunkt 55 berührt das Antriebselement 30 und bewegt dieses in eine gewünschte Richtung. Dies gilt für alle drei Antriebe aus den Fig. 2A, 2B und 2C.

Die Aktuatorelemente 52, 54 können durch ihre periodischen Bewegungen einen periodischen Ungleichlauf des Antriebselements 30 hervorrufen. Ein periodischer Ungleichlauf des o.g. Antriebs ist insbesondere störend, wenn der Aktuator nur gestellt wird (d.h. kein Rückkopplungssignal aus einer Messung zur Verfügung steht). Bei kontinuierlichem Betrieb entstehen hierdurch periodische Störungen des mit dem Antrieb betätigten Systems, die sich zum Beispiel auf in dem betätigten System vorgenommene Messungen auswirken können. So können diese Störungen z.B. direkt in einem relevanten Frequenzbereich liegen.

Als Beispiel kann ein Teleskop oder Interferometer, welches mit Hilfe des Antriebs 10 eine gewünschte Bewegung ausführen soll, genannt werden. Ein solches System muss mit einer langsamen Winkelbewegung über einen vergleichsweise großen Winkelbereich bewegt werden und gleichzeitig ein sehr niedriges frequenzabhängiges Rauschen bieten. Grundsätzlich eignet sich ein Piezo-Friktionsantrieb für einen solchen Verwendungszweck. Mit dem hier beschriebenen Verfahren kann das System so gestellt werden, dass sich ein periodischer Ungleichlauf nur sehr gering oder gar nicht auswirkt und eine sehr gleichmäßige Bewegung des Systems erreicht wird.

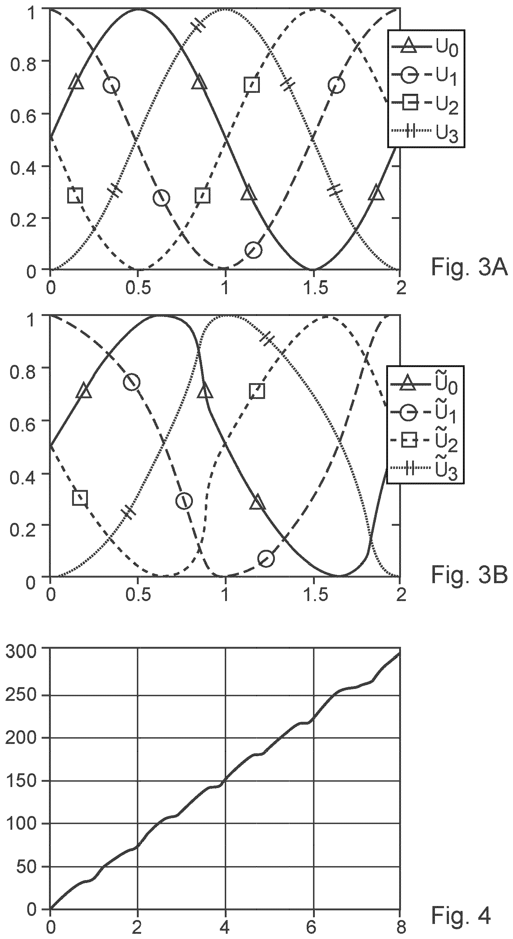

Fig. 3A zeigt ein mehrphasiges Ansteuersignal mit vier Phasen U0, U1, U2, U3. Hierbei handelt es sich in diesem Beispiel um gleichmäßige Sinus-Signale. Diese Signale berücksichtigen den periodischen Ungleichlauf eines Antriebs nicht.

In Fig. 3B ist ein modifiziertes mehrphasiges Ansteuersignal gezeigt, welches den periodischen Ungleichlauf des Antriebes berücksichtigt und die Aktuatorelemente so ansteuert, dass sich das Antriebselement gleichmäßig bewegt. Es ist zu erkennen, dass sämtliche Phasen $\tilde{U}_0(\phi)$, $\tilde{U}_1(\phi)$, $\tilde{U}_2(\phi)$, $\tilde{U}_3(\phi)$ im Vergleich zu der Darstellung in Fig. 3A einen geänderten Verlauf über der Zeit haben.

Bezugnehmend auf die Fig. 3A und 3B wird beispielhaft und nicht einschränkend ein Optimierungsverfahren für Ansteuerspannungen von Piezo-Friktionsantrieben beschrieben.

Bei Piezo-Friktionsantrieben erfolgt die interne Ansteuerung mit den vier Spannungen $U_j(\phi), j \in \{0,1,2,3\}$, wie mit Bezug zu Fig. 2A bis 2C beschrieben. Durch den identischen Aufbau der beiden Gruppen A und B (vgl. Fig. 2A bis 2C) gilt üblicherweise außerdem $U_j(\phi) = U_{j-2}(\phi - \pi), j \in \{2,3\}$, weshalb es ausreicht die ersten beiden Spannungen zu untersuchen.

Somit kann die Optimierung in Form der Spannungen $\tilde{U}_j(\phi) = U_j(\psi(\phi))$ implementiert werden.

In einem beispielhaften und auf Biege-Piezoantriebe bezogenen Fall erfolgt die Ansteuerung hierbei anfänglich über die vier einfachen harmonischen Funktionen

$$U_j(\phi) = \frac{U_{amp}}{2} \cdot \left[1 + \cos\left(\phi - \frac{\pi}{2}j\right)\right], j \in \{0,1,2,3\}$$

welche in Fig. 3A gezeigt sind, woraus sich nach der oben ausgeführten Optimierung nichttriviale optimierte Spannungen ergeben. Dies ist in Fig. 3B exemplarisch dargestellt.

Weiterhin beispielhaft und nicht einschränkend wird im Folgenden ein Ansatz beschrieben, der er ermöglicht, verbesserte Anfangsannahmen für Piezo-Friktionsantriebe zu erzeugen.

Um für Piezo-Friktionsantriebe eine optimal rauscharme Bewegung zu erreichen, empfiehlt es sich, von einer modellbasiert bestimmten Wellenform als Startpunkt für die oben beschriebene Optimierung auszugehen. Hierzu kann die zweidimensionale Bewegung der Aktuatoreinheiten im einfachsten Fall (d.h. ohne Berücksichtigung von Hystereseeffekten) über ein lineares Modell mit den Ansteuerspannungen verknüpft werden:

$$\begin{pmatrix} x_A(\phi) \\ y_A(\phi) \end{pmatrix} = \begin{pmatrix} m_{11} & m_{12} \\ m_{21} & m_{22} \end{pmatrix} \begin{pmatrix} U_0(\phi) \\ U_1(\phi) \end{pmatrix} = \boldsymbol{M} \cdot \begin{pmatrix} U_0(\phi) \\ U_1(\phi) \end{pmatrix},$$

wobei $x_A$ die Auslenkung entlang der Antriebsrichtung (also der Bewegung des Antriebselements) und $y_A$ die Auslenkung orthogonal hierzu ist. Die Linearisierung ist eine gute Näherung, da die Deformationen der Piezo-Aktuatoreinheiten klein gegenüber ihren Abmessungen sind. Verschiedene Aktuatorgeometrien (vgl. Fig. 2A bis 2C) können über die Koeffizienten der Matrix $\boldsymbol{M}$ berücksichtigt werden. Für Biege-Piezo-Antriebe sowie die

Wander-Piezoantriebe gilt $m_{12} = -m_{11}$ und $m_{22} = m_{21}$, für Klemm-Scher-Antriebe gilt dagegen $m_{11} = m_{22} = 0$, wodurch jeweils nur zwei Koeffizienten aus der Geometrie oder aus Messungen bestimmt werden müssen.

Nun werden verschiedene Randbedingungen an eine geeignete Bewegung der Aktuatoreinheiten gestellt:

1. $x_A(\phi)$ und $y_A(\phi)$ sind $2\pi$-periodisch, d.h. $x_A(\phi) + 2\pi) = x_A(\phi)$ und $y_A(\phi + 2\pi) = y_A(\phi)$.

2. Es gibt genau eine Phase $\phi = \phi_0$ im Intervall [0,2$\pi$[, für die $y_A(\phi_0) = y_A(\phi_0 + \pi)$ und $y_A(\phi_0) < y_A(\phi)$ für $\phi \in ]\phi_0, \phi_0 + \pi[$, sowie $y_A(\phi_0) > y_A(\phi)$ für $\phi \in ]\phi_0 - \pi, \phi_0[$. Für $\phi \in ]\phi_0, \phi_0 + \pi[$ sorgt somit die Gruppe A der Aktuatoreinheiten für den Vorschub.

3. Die laterale Geschwindigkeit der lasttragenden Aktuatoreinheit ist möglichst konstant, d.h. $\frac{dx_A}{d\phi}(\phi) = const$ . für $\phi \in [\phi_0, \phi_0 + \pi]$. Dies sorgt für eine stetige Bewegung des Antriebs, insbesondere auch an den Übergabepunkten zwischen den einzelnen Gruppen von Aktuatoreinheiten.

4. Die vertikale Geschwindigkeit an den Übergabepunkten sollte möglichst klein sein. Zudem sollte die absolute vertikale Geschwindigkeit der lasttragenden Aktuatoreinheiten kleiner als die der nichtlasttragenden Aktuatoreinheiten sein.

5. Die Bewegungen in beiden Achsen sollen möglichst glatt bzw. gleichmäßig verlaufen, d.h. zumindest stetig differenzierbar sein.

Eine mögliche Realisierung, die diese Anforderungen erfüllt, ist durch folgende Funktionen gegeben:

$$x_A(\phi) = \frac{3\sqrt{6}}{4\pi} x_0 \cdot \begin{cases} \phi, & -\frac{\pi}{2} \leq \phi \leq \frac{\pi}{2} \\ \left(\frac{2}{\pi}\right)^2 (\phi - \pi)^3 - 2(\phi - \pi), & \frac{\pi}{2} < \phi < \frac{3\pi}{2} \end{cases}$$

$$y_A(\phi) = \frac{1}{2}\left[1 + \cos\left(\frac{\phi^2}{\pi}\right)\right], \qquad -\pi < \phi \leq \pi$$

Die Funktion $x_A(\phi)$ entsteht durch Ergänzen einer linearen Funktion mit einem Polynom dritter Ordnung, unter Einhaltung der oben beschriebenen Anschlussbedingungen. Die Funktion $y_A(\phi)$ ist eine glatte Funktion, die ebenfalls obige Bedingungen erfüllt. Die additive Konstante kann je nach Piezo-Parametern angepasst werden (insbesondere für unipolaren oder bipolaren Betrieb). Beide Funktionen sind außerhalb des definierten Bereichs periodisch fortzusetzen.

Die Übergabepunkte zwischen den Gruppen A und B der Aktuatoreinheiten liegen bei $\phi_0 = \frac{3}{2}\pi$ und $\phi_1 = \frac{1}{2}\pi$ .

Hieraus ergeben sich durch Inversion obigen Modells, also über

$$\begin{pmatrix} U_0(\phi) \\ U_1(\phi) \end{pmatrix} = \boldsymbol{M^{-1}} \cdot \begin{pmatrix} x_A(\phi) \\ y_A(\phi) \end{pmatrix}$$

die gesuchten Ansteuerspannungen, die als Startpunkt der anschließenden Optimierung genutzt werden können.

Fig. 4 zeigt die gemessene Bewegung $a(\phi)$ eines Antriebselements auf der vertikalen Achse über der Aktuatorphase $\phi$ ($\pi$ rad) (Ansteuersignal) bei einfacher Ansteuerung auf der horizontalen Achse. Es ist zu erkennen, dass die Bewegung nicht gleichmäßig erfolgt, weil sich die Bewegung nicht gleichmäßig über der Aktuatorphase verändert.

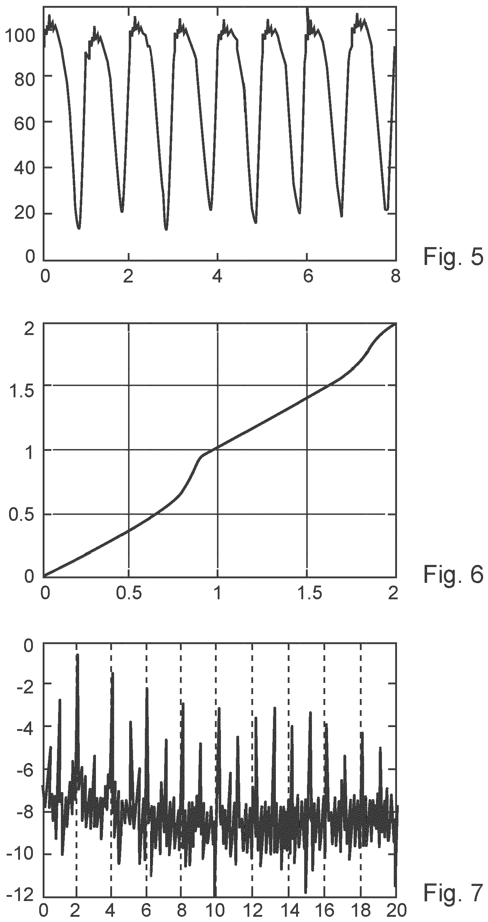

Fig. 5 zeigt die Änderung der Bewegung (also die Geschwindigkeit) des Antriebselements über der Aktuatorphase $\phi$ ($\pi$ rad). Hierbei handelt es sich um ein periodisches Signal, welches den periodischen Ungleichlauf der Aktuatoreinheit wiedergibt. Die erfasste Kurve verläuft in der Regel nicht gleichmäßig, sondern hat abschnittsweise hochfrequente Störungen bzw. Anteile.

Ziel ist es nun, das Ansteuersignal für die Aktuatoreinheiten so zu verändern, dass die Bewegung des Antriebselements gleichmäßig und unabhängig von dem periodischen Ungleichlauf der Aktuatoreinheiten wird.

Fig. 6 zeigt die in diesem Beispiel abgeleitete Korrekturfunktion $\psi(\phi)$ ($\pi$ rad) über der Aktuatorphase $\phi$ ($\pi$ rad) und Fig. 7 zeigt die Fourier-Koeffizienten b, die bei der Filterung genutzt wurden.

In diesem Beispiel wurde gefordert, dass die Ansteuerspannung der beiden Gruppen A und B der Aktuatoreinheiten bis auf Phasenverschiebung identisch sein sollen, weshalb die Filterung nur die Fourier-Koeffizienten mit geradzahligen Indizes berücksichtigt. Hierdurch wird die Kurve aus Fig. 5 von nichtperiodischen Anteilen befreit, was hierin als Filtervorgang bezeichnet wird. Ebenso werden aus der Kurve in Fig. 5 auch Unterschiede zwischen den Bewegungen der Aktuatorgruppen A und B entfernt. Fig. 6 ist also die invertierte Bewegungsfunktion, welche verwendet wird, um das modifizierte Ansteuersignal zu ermitteln.

In einer alternativen Variante können wahlweise alle Fourier-Koeffizienten berücksichtigt werden, was dazu führen würde, dass in diesem Beispiel keine der vier Ansteuerspannungen bis auf Phasenverschiebung mit einer anderen identisch wäre. Die Korrekturfunktion ergibt sich in der graphischen Darstellung im Wesentlichen auch einfach aus der gefilterten Kurve der in Fig. 4 gezeigten Kurve durch Skalierung und Vertauschen der Achsen.

Zusammengefasst zeigt Fig. 4 die tatsächliche Bewegung des Antriebselements über dem Ansteuersignal. Fig. 5 zeigt die Änderung der Bewegung über dem Ansteuersignal. Die Änderung der Bewegung wird einer Fourier-Transformation unterzogen und dann mit ausgewählten Fourier-Koeffizienten rücktransformiert, um ein gefiltertes Signal zu erzeugen. Dieses gefilterte Signal ist die Basis, um das modifizierte Ansteuersignal zu bestimmen, welches den periodischen Ungleichlauf der Aktuatoreinheiten berücksichtigt, um eine gleichmäßige Bewegung des Antriebselements herbeizuführen.

In einem Beispiel kann die Herangehensweise zum Bestimmen des modifizierten Ansteuersignals mit weiterer Bezugnahme auf die Fig. 4 bis 7 und die bisherige Beschreibung auch wie folgt beschrieben werden:

In diesem Beispiel wird die Position eines Antriebselements als Bewegung dargestellt. Dies soll jedoch keinesfalls die Anwendung des Verfahrens auf das Verwenden der Position des Antriebselements einschränken. In anderen Beispielen kann auch die Geschwindigkeit oder die Beschleunigung oder eine andere geeignete Größe verwendet werden, um die Bewegung des Antriebselements zu beschreiben.

Als Eingangssignal eines Antriebs diene eine Phase $\phi$, welche die interne Periodizität des Mechanismus (d.h. der Aktuatoreinheiten) berücksichtigt. Die Phase $2\pi$ entspricht somit einem Zyklus der internen Vorgänge (z.B. Drehung einer Spindel, Schritt einer Laufbewegung, etc.).

Das Verfahren erfordert das Ermitteln der Antriebsposition $a(\phi)$ als Funktion des Eingangssignals (Ansteuersignal), z.B. indem die Bewegung in Abhängigkeit des Ansteuersignals gemessen oder aus einem Datenbestand ausgelesen wird. $a$ ist die aktuierte Größe (z.B. Winkel oder Position, allgemein die Bewegung des Antriebselements). Das Verfahren ist durch Vermessung zahlreicher Aktuatorperioden sowie harmonische Filterung sehr robust gegen Messrauschen, erfordert aber möglichst kleine Nichtlinearitäten der Messeinrichtung. Hierzu kann ein geeignetes Interferometer (z.B. optisch), ein kapazitiver Sensor, ein opto-mechanischer Encoder oder eine andere geläufige Messmethode eingesetzt werden. Zum späteren Betrieb des Antriebs ist keine Messeinrichtung mehr erforderlich.

Im Allgemeinen funktioniert das Verfahren folgendermaßen: Die gemessene Antriebsposition $a(\phi)$ wird so zu einer Funktion $A(\phi)$ gefiltert, dass nur der lineare Anstieg mit $\phi$ (mit einer Steigung $\frac{c_0}{2\pi}$ ) sowie die Harmonischen der durch die Periode $2\pi$ gegebenen Grundschwingung übrig bleiben. Nun wird durch Lösen der Gleichung $A(\psi) = \frac{c_0}{2\pi}\phi$ eine (bis auf einen linearen Anstieg ebenfalls perfekt periodische) Funktion $\psi(\phi)$, bestimmt. Wird nun der Antrieb statt mit dem Eingangssignal $\phi$ mit dem Signal $\psi(\phi)$ angesteuert, folgt die Antriebsposition der Funktion $A(\psi(\phi)) = \frac{c_0}{2\pi}\phi$ , d.h. einer im Eingangssignal linearen Funktion. Somit sind durch die internen Vorgänge des Antriebs hervorgerufene deterministische periodische Störungen - auch im Betrieb ohne Messeinrichtung oder Regelkreis - bestmöglich (d.h. im Rahmen der Messgenauigkeit und Reproduzierbarkeit) aus der Bewegung eliminiert.

Im Falle von hysteresebehafteten internen Vorgängen (z.B. bei Piezo-Aktuatoren) kann das Verfahren auch mehrfach (iterativ) angewandt werden, um eine weiter verbesserte Ansteuerfunktion $\psi_1 (\psi_2 (... (\psi_p(\phi))))$ zu erhalten. In diesem Fall kann es außerdem vorteilhaft sein, zwei Bewegungsrichtungen des Antriebselements gesondert zu optimieren. Im Detail kann das Verfahren in einem Beispiel wie folgt implementiert werden:

Der Antrieb wird mit einer zeitabhängigen Phase $\phi(t) = \omega_0 \cdot t$ über mindestens n = 1 Aktuatorperioden (periodische Bewegungen der Aktuatoreinheiten) angesteuert. Bevorzugt erfolgt dies über mehrere Aktuatorperioden, beispielsweise $n \geq 10$ ($n \in \mathbb{N}$). Je mehr Aktuatorperioden genutzt werden, umso besser kann nichtperiodisches Rauschen unterdrückt werden. Falls erforderlich kann ein Vor- oder Nachlauf hinzugefügt werden.

Die Antriebsposition (allgemein: Bewegung des Antriebselements) wird gemessen, und zu äquidistanten, diskreten Zeiten $t_j = \frac{2\pi}{m \cdot \omega_0} j = \frac{\Delta\phi}{\omega_0} j = \frac{1}{\omega_0} \phi_j \ (m, j \in \mathbb{N})$ , entsprechend äquidistanten Eingangssignalen $\phi_j$ aufge-zeichnet, bevorzugt mit m $\geq$ 16 Aufzeichnungen pro Aktuatorperiode. Das Messsignal ist somit $a_j = a(\phi_j)$.

Nun wird die Größe $b_j = a_{j+1} - a_j$ ($j = 0 ... N - 1$, $N = n \cdot m$) berechnet. Dieses Differential ist einer numerischen Ableitung der Funktion $a(\phi)$ an der Stelle $\phi_j + \frac{\Delta\phi}{2}$ proportional. Hierdurch wird die nominelle Eingangsphasenabhängigkeit des Messsignals (üblicherweise ein lineares Anwachsen) entfernt. Dies ist insbesondere vorteilhaft, sofern im folgenden Filterungsschritt zur Glättung des Signals nicht alle Harmonischen berücksichtigt werden sollen, da der lineare Anstieg bei Fourier-Filterung zu einem breiten Harmonischenspektrum führen würde.

Das Resultat wird gefiltert, um periodische Anteile von nichtperiodischem Rauschen zu trennen. Hierzu werden Fourier-Koeffizienten berechnet:

$$c_k = \frac{1}{n} \sum_{j=0}^{N-1} b_j e^{-i\frac{2\pi}{m}\cdot j \cdot k}, \, k = 0 \ldots \frac{m}{2} - 1$$

Die Koeffizienten $c_k$ lassen sich auch aus der Fourier-Transformation $\tilde{b}_k$ der Koeffizienten $b_k$ bestimmen (z.B. über eine schnelle Fourier-Transformation, FFT), indem jeweils der $n$ -te Wert genutzt wird, also $c_k = \frac{1}{n}\tilde{b}_{n\cdot k}$ . Das gefilterte, exakt periodische Signal $A(\phi)$ lässt sich als harmonische Summe wie folgt darstellen:

$$A(\phi) = \frac{c_0}{2\pi}\phi + \sum_{k=1}^{\frac{m}{2}-1} \Re\left(\frac{c_k}{i\pi k}\left[e^{ik(\phi - \frac{1}{2}\Delta\phi)} - e^{-\frac{1}{2}ik\Delta\phi}\right]\right).$$

Die nominelle Geschwindigkeit des Antriebs bezogen auf die Eingangsphase ist $\frac{c_0}{2\pi}$, die anderen Koeffizienten entsprechen Amplituden der unerwünschten Harmonischen der antriebsinternen Vorgänge. Die Summe ist zudem so konstruiert, dass $A(0) = 0$ gilt. Je nach Antrieb und Messrauschen kann es im Einzelfall sinnvoll sein, die obere Summationsgrenze zu reduzieren, d.h. weniger Harmonische im weiteren Verfahren zu berücksichtigen. Ebenso kann - z.B. bei Anwendung des Verfahrens für Piezo-Friktionsantriebe - sinnvoll sein, die Summation auf geradzahlige Indizes $k$ zu beschränken, um sicherzustellen, dass beide Aktuatorgruppen mit bis auf eine Phasenverschiebung identischen Signalen angesteuert werden. Die Filterung ist vergleichbar auch direkt für die Koeffizienten $a_j$ - unter Auslassung des Differentiationsschrittes - möglich, allerdings mit den oben genannten Einschränkungen.

Nun wird die Gleichung $A(\psi) = \frac{c_0}{2\pi}\phi$ numerisch nach $\psi$ aufgelöst. Dies ist nur möglich, sofern $A(\psi)$ monoton in $\psi$ ist, was gleichzeitig auch eine Bedingung für die Anwendbarkeit des vorgestellten Verfahrens ist. $\psi(\phi)$ ist wiederum exakt periodisch, wodurch die numerische Lösung z.B. durch Auswertung von $A(\psi)$ für hinreichend viele Punkte von $\psi$ im Intervall $[0, 2\pi]$ erfolgen kann. Anschließend lässt sich die gewonnene Funktion $\psi_{2\pi}(\phi)$ durch stetiges Aneinanderfügen auf größere Phasenintervalle erweitern, also

$$\psi(\phi) = \psi_{2\pi}\left(\phi - 2\pi\left\lfloor\frac{\phi}{2\pi}\right\rfloor\right) + 2\pi\left\lfloor\frac{\phi}{2\pi}\right\rfloor.$$

Alternativ hierzu kann ein Algorithmus zur Bestimmung der Fourier-Koeffizienten der periodischen invertierten Funktion eingesetzt werden.

Ggf. kann zur iterativen Verbesserung (z.B. im Fall hysteresebehafteter Antriebe) das Verfahren erneut durchlaufen werden, nun aber mit einer Ansteuerung des Antriebs gemäß dem Signal $\psi(\omega)_0 \cdot t$).

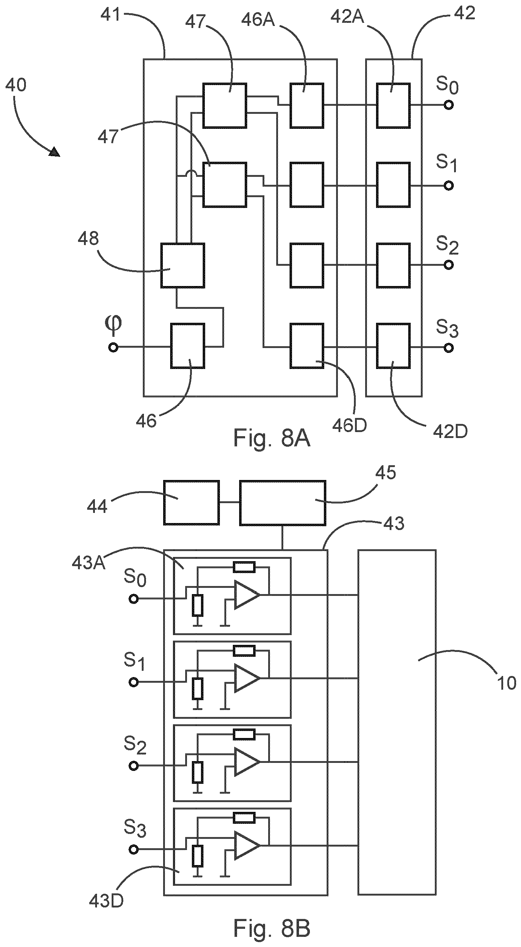

Fig. 8A und 8B zeigen eine Steuereinheit 40 zum Ansteuern eines Aktuators. Auch wenn in den Fig. 8A und 8B einige Komponenten gesondert dargestellt werden, so können diese Komponenten gemeinsam die Steuereinheit 40 bilden.

Die gewünschten Trajektorien der Aktuatoreinheiten 50 (siehe Fig. 2A bis 2C, Bewegung des Antriebspunkts 55) können über die Amplituden der Ansteuerspannungen räumlich vergrößert oder verkleinert werden. Im Rahmen der mechanischen Toleranzen können die Spannungen insbesondere auf kleinere Werte als die sonst für Piezoantriebe üblichen Werte reduziert werden. Hierbei wird in Kauf genommen, dass der Vorschub pro Aktorperiode ebenfalls abnimmt. Gleichzeitig kann ein zusätzlicher konstanter Spannungsoffset genutzt werden, um den Betriebsbereich der Piezoelemente bestmöglich auszunutzen. Diese Skalierung und Verschiebung kann auf die Ansteuerspannungen vor deren Optimierung angewandt werden, da das Verfahren zur Optimierung die Spannungsamplituden unverändert lässt.

Besonders vorteilhaft ist die Skalierung auf unipolare Spannungen kleiner Amplitude, da die Elektronik zur Ansteuerung des Antriebs dann besonders kompakt und einfach aufgebaut werden kann.

Die Steuereinheit 40 enthält eine Recheneinheit 41, einen Digital-Analog-Wandler (DAC) 42, (Fig. 8A) einen Verstärker 43 (Fig. 8B) zur Ansteuerung der Aktuatoren, sowie einer Energieversorgung mit Spannungsquelle 44 und Spannungsversorgung 45 für den Verstärker 43.

Optional kann vor oder nach dem Verstärker 43 ein Umschalter angeordnet sein, wobei die Elemente vor dem Umschalter doppelt vorgehalten werden können, um eine Redundanzumschaltung vornehmen zu können.

Die Recheneinheit 41 erzeugt aus einer Eingangsphase $\phi$ vier Ausgangssignale, um einen Piezo-Friktionsantrieb anzusteuern. Wahlweise kann die Recheneinheit 41 (z.B. ausgestaltet als Microcontroller, Computer, oder FPGA) die Ausgangssignale berechnen oder aus einer eingespeicherten Tabelle auslesen. Im ersten Fall können über o.g. Verfahren bestimmte Fourier-Koeffizienten von $\psi(\phi)$ bzw. Koeffizienten einer geeigneten Regressionsfunktion, die an das numerisch bestimmte $\psi(\phi)$ angepasst ist, in Kombination mit den zur Anregung genutzten Funktionen $U_j(\phi)$ zur Berechnung herangezogen werden. Alternativ können die korrigierten bzw. optimierten Funktionen $\tilde{U}_j(\phi)$ über geeignete Regressionskoeffizienten direkt berechnet werden. Im zweiten Fall (d.h. der Auslesung aus einem Speicher) soll die Recheneinheit auf mindestens zwei gespeicherte Wellenformen $\tilde{U}_0(\phi)$ und $\tilde{U}_1(\phi)$ für $\phi \in [0,2\pi[$ (gleichermaßen äquidistant in der Phase diskretisiert) zugreifen können. Die Recheneinheit wandelt dann die Ansteuerphase $\phi$ als Eingangssignal über Bit-Dithering (Rauschformung) in einen Index 48 in beide Wellenformspeicher 47 um, wobei dieser Index modulo der Speicherbreite genommen wird, um eine periodische Fortsetzung der Wellenform zu erhalten. Zusätzlich wird ein Index generiert, der um die Phase $\pi$, d.h. eine halbe Speicherbreite, verschoben ist. Beide Speicher werden an beiden Indizes ausgelesen. Bevorzugt erfolgt dieser Vorgang mit hoher Frequenz (> 100 kHz), um durch das Bit-Dithering eine hohe Auflösung bei moderater Speichergröße zu erhalten. Das Bit-Dithering wird in Rauschformungseinheiten 46, 46A-46D vorgenommen. Jeweils eine Rauschformungseinheit 46A-46D ist einem der vier Signale zugeordnet.

Die vier erzeugten Signale werden mittels des DAC 42 in analoge Spannungen oder Ströme übersetzt und als Signale S0 bis S3 über jeweils einen DAC-Kanal 42A, 42D ausgegeben. Bevorzugt erfolgt die Ausgabe mit einer hohen Frequenz (im Falle der Wellenformspeicher z.B. die Frequenz der Speicherauslesung), um durch das Bit-Dithering bei niedrigen Frequenzen eine hohe Auflösung bei moderater DAC-Auflösung zu erhalten. Ebenfalls bevorzugt kommt ein vierkanaliger DAC-Chip zum Einsatz, um alle vier Phasen auszugeben.

Die DAC-Spannungen oder Ströme S0 bis S3 aus Fig. 8A werden auf den in Fig. 8B gezeigten Verstärker 43 geführt und linear auf eine für die Aktuatoren geeignete Spannungsamplitude verstärkt. Bevorzugt kommt ein rauscharmer Operationsverstärker zum Einsatz, der direkt die für die Aktuatoren benötigten Spannungen erzeugen kann. Ebenfalls bevorzugt kommt ein vierkanaliger Operationsverstärker zum Einsatz, je nach Eingangssignal beschaltet als Spannungsverstärker oder als Transimpedanzverstärker.

Außerdem bevorzugt sind die Ausgangssignale und damit auch die Versorgungsspannung des Verstärkers 43 unipolar. Vorteilhaft für Anwendungen in Satelliten ist, wenn die Maximalspannung des Verstärkers 43 kleiner als die Busspannung des Satelliten ist, so dass die Spannungsversorgung des Verstärkers direkt aus dem Bus abgeleitet werden kann.

Bevorzugt wird eine Energieversorgung mit einer unipolaren Spannungsquelle 44 genutzt (z.B. ein Satellitenbus mit einer typischen Spannung zwischen 40 V und 60 V), die über einen geeigneten Spannungsregler 45 auf eine Spannung etwas oberhalb der maximalen benötigten Ausgangsspannung des Verstärkers stabilisiert wird. Dieser Spannungsregler 45 ist bevorzugt ein linearer Spannungsregler.

Die Recheneinheit 41, der Digital-Analog-Wandler 42 und der Verstärker 43 können redundant vorgehalten werden. Ein Redundanzumschalter kann verwendet werden, um auszuwählen, welche Recheneinheit 41, Digital-Analog-Wandler 42 und Verstärker 43 mit dem Antrieb verbunden werden.

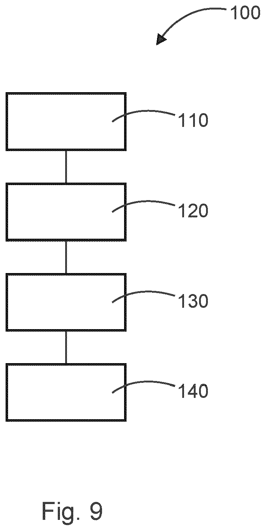

Fig. 9 zeigt eine schematische Darstellung des Ablaufs der Schritte eines Verfahrens zum Steuern eines Antriebs 10 mit einem Aktuator 20 mit periodischem Ungleichlauf gemäß einem Beispiel.

In einem ersten Schritt 110 wird ein Bewegungsmusters des Antriebs empfangen, wobei das Bewegungsmuster eine ausgeführte Bewegung und ein zugehöriges Ansteuersignal des Antriebs aufweist. In einem zweiten Schritt 120 wird eine Bewegungsfunktion des Antriebs basierend auf dem Bewegungsmuster ermittelt, wobei die Bewegungsfunktion die ausgeführte Bewegung über dem zugehörigen Ansteuersignal darstellt. In einem dritten Schritt 130 wird die Bewegungsfunktion des Antriebs invertiert, um eine invertierte Bewegungsfunktion zu erhalten, wobei die invertierte Bewegungsfunktion das Ansteuersignal über der ausgeführten Bewegung darstellt. In einem vierten Schritt 140 wird der Antrieb gemäß der invertierten Bewegungsfunktion angesteuert, wobei ein Ansteuersignal zum Ausführen einer vorgegebenen Bewegung aus der invertierten Bewegungsfunktion entnommen wird.

Das Verfahren mit diesem Schritten kann in der Steuereinheit 40 (beispielhaft gezeigt in Fig. 8A, 8B) implementiert sein, d.h. das Verfahren wird realisiert, indem Befehle von der Steuereinheit ausgeführt werden, wobei die Befehle die Steuereinheit veranlassen, die Schritte des Verfahrens auszuführen.

Ergänzend ist darauf hinzuweisen, dass "umfassend" oder "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

Bezugszeichenliste

| 10 | Antrieb |
| 20 | Aktuator |
| 30 | Antriebselement |
| 40 | Steuereinheit |
| 41 | Recheneinheit |
| 42 | Digital-Analog-Wandler |
| 42A | Kanal |
| 43 | Verstärker |
| 43A | Verstärkerkanal |
| 44 | Spannungsquelle |
| 45 | Spannungsregler |
| 46 | Rauschformungseinheit |
| 50 | Aktuatoreinheit |
| 52 | Aktuatorelement |
| 54 | Aktuatorelement |
| 55 | Antriebspunkt |
| 100 | Verfahren |

**Patentansprüche**

1.  Verfahren zum Steuern eines Antriebs (10) mit einem Aktuator (20) mit periodischem Ungleichlauf, wobei das Verfahren die folgenden Schritte aufweist:

    Empfangen eines Bewegungsmusters des Antriebs, wobei das Bewegungsmuster eine ausgeführte Bewegung und ein zugehöriges Ansteuersignal des Antriebs aufweist;
    Ermitteln einer Bewegungsfunktion des Antriebs basierend auf dem Bewegungsmuster, wobei die Bewegungsfunktion die ausgeführte Bewegung über dem zugehörigen Ansteuersignal darstellt;
    Invertieren der Bewegungsfunktion des Antriebs, um eine invertierte Bewegungsfunktion zu erhalten, wobei die invertierte Bewegungsfunktion das Ansteuersignal über der ausgeführten Bewegung darstellt;
    Ansteuern des Antriebs gemäß der invertierten Bewegungsfunktion, wobei ein Ansteuersignal zum Ausführen einer vorgegebenen Bewegung aus der invertierten Bewegungsfunktion entnommen wird.

2.  Verfahren nach Anspruch 1, weiterhin aufweisend die Schritte:

    Ansteuern des Antriebs (10) mit einem zeitabhängigen Ansteuersignal über mindestens eine Aktuatorperiode;
    Erfassen einer von dem Antrieb ausgeführten Bewegung in Abhängigkeit von dem zeitabhängigen Ansteuersignal;
    Erstellen des Bewegungsmusters des Antriebs basierend auf dem zeitabhängigen Ansteuersignal und der ausgeführten Bewegung.

3.  Verfahren nach Anspruch 2,
    wobei die von dem Antrieb in Abhängigkeit von dem zeitabhängigen Ansteuersignal ausgeführte Bewegung zu äquidistanten Werten des Ansteuersignals und mehrfach für jede Aktuatorperiode erfasst wird.

4.  Verfahren nach Anspruch 3,

    wobei das Erfassen einer von dem Antrieb ausgeführten Bewegung das Erfassen einer von dem Antrieb angefahrenen Position enthält;
    wobei für die angefahrene Position zu jedem diskreten Messpunkt eine Differenz zu der angefahrenen Position des unmittelbar vorangegangenen Messpunktes ermittelt wird, wobei die ermittelte Differenz für die Gesamtheit der Messpunkte einer numerischen Ableitung der angefahrenen Position entspricht.

5.  Verfahren nach einem der Ansprüche 2 bis 4,

wobei die erfasste ausgeführte Bewegung gefiltert wird, um periodische Anteile von nicht-periodischen Anteilen zu trennen.

6. Verfahren nach einem der Anspruch 5,
wobei die erfasste ausgeführte Bewegung gefiltert wird, indem die erfasste ausgeführte Bewegung einer Fourier-Transformation unterzogen wird, zugehörige Fourier-Koeffizienten bestimmt werden, und basierend auf den bestimmten Fourier-Koeffizienten eine Fourier-Rücktransformation erfolgt.

7. Verfahren nach einem der Ansprüche 2 bis 6,
wobei das Ansteuersignal gemäß der invertierten Bewegungsfunktion zum Ansteuern des Antriebs (10) mit einem zeitabhängigen Ansteuersignal über mindestens eine Aktuatorperiode verwendet wird.

8. Verfahren nach einem der voranstehenden Ansprüche,

wobei der Aktuator (20) eine Mehrzahl von Aktuatoreinheiten (50) aufweist;
wobei jede Aktuatoreinheit (50) mindestens zwei Aktuatorelemente (52, 54) aufweist;
wobei als Ansteuersignal ein mehrphasiges Signal mit einer Phase für jedes Aktuatorelement (50) erzeugt wird.

9. Verfahren nach Anspruch 8,
wobei das mehrphasige Signal so ausgestaltet ist, dass eine periodische Bewegung der Aktuatoreinheiten in einer linearen oder rotatorischen Bewegung eines Antriebselements (30) des Antriebs (10) resultiert.

10. Verfahren nach Anspruch 8 oder 9,
wobei die Aktuatoreinheiten (50) der Mehrzahl von Aktuatoreinheiten (50) in zwei Gruppen unterteilt sind und jeweils die Aktuatoreinheiten einer Gruppe synchron mit gleichen Phasen angesteuert werden.

11. Verfahren nach einem der Ansprüche 8 bis 10,
wobei jede Aktuatoreinheit (50) eine Piezo-Einheit mit zumindest zwei Piezo-Elementen ist, wobei die Piezo-Elemente so miteinander verbunden sind, dass die Piezo-Einheit eine zweidimensionale Bewegung ausführen kann.

12. Verfahren nach einem der voranstehenden Ansprüche,
wobei zum Erzeugen des Ansteuersignals eine unipolare Spannungsquelle verwendet wird.

13. Verfahren nach einem der voranstehenden Ansprüche,
wobei das Verfahren zum Einstellen einer Position eines rückkopplungsfreien Antriebs verwendet wird.

14. Steuereinheit (40) zum Steuern eines Antriebs (10) mit einem Aktuator (20) mit periodischem Ungleichlauf, wobei die Steuereinheit (40) ausgeführt ist, zum:

Empfangen eines Bewegungsmusters des Antriebs, wobei das Bewegungsmuster eine angefahrene Position und ein zugehöriges Ansteuersignal des Antriebs aufweist;
Ermitteln einer Bewegungsfunktion des Antriebs basierend auf dem Bewegungsmuster, wobei die Bewegungsfunktion die angefahrene Position über dem zugehörigen Ansteuersignal darstellt;
Invertieren der Bewegungsfunktion des Antriebs, um eine invertierte Bewegungsfunktion zu erhalten, wobei die invertierte Bewegungsfunktion das Ansteuersignal über der angefahrenen Position darstellt;
Ansteuern des Antriebs gemäß der invertierten Bewegungsfunktion, wobei ein Ansteuersignal zum Anfahren einer vorgegebenen anzufahrenden Position aus der invertierten Bewegungsfunktion entnommen wird.

15. Steuereinheit (40) nach Anspruch 14,
wobei die Steuereinheit (40) ausgeführt ist zum:

Ansteuern des Antriebs (10) mit einem zeitabhängigen Ansteuersignal über mindestens eine Aktuatorperiode;
Erfassen einer von dem Antrieb ausgeführten Bewegung in Abhängigkeit von dem zeitabhängigen Ansteuersignal;
Erstellen des Bewegungsmusters des Antriebs basierend auf dem zeitabhängigen Ansteuersignal und der ausgeführten Bewegung.

**Claims**

1.  Method for controlling a drive (10) having an actuator (20) with periodic irregularity, wherein the method comprises the following steps:

    receiving a movement pattern of the drive, wherein the movement pattern contains a performed movement and an associated actuation signal of the drive;
    ascertaining a movement function of the drive based on the movement pattern, wherein the movement function represents the performed movement over the associated actuation signal;
    inverting the movement function of the drive to obtain an inverted movement function, wherein the inverted movement function represents the actuation signal over the performed movement;
    actuating the drive according to the inverted movement function, wherein an actuation signal for performing a predefined movement is derived from the inverted movement function.

2.  Method according to Claim 1, furthermore comprising the following steps:

    actuating the drive (10) with a time-dependent actuation signal over at least one actuator period;
    acquiring a movement performed by the drive on the basis of the time-dependent actuation signal;
    creating the movement pattern of the drive based on the time-dependent actuation signal and the performed movement.

3.  Method according to Claim 2,
    wherein the movement performed by the drive on the basis of the time-dependent actuation signal is acquired at equidistant values of the actuation signal and multiple times for each actuator period.

4.  Method according to Claim 3,

    wherein acquiring a movement performed by the drive comprises acquiring a position travelled to by the drive;
    wherein, for the position travelled to, at each discrete measurement point, a difference from the position travelled to of the immediately preceding measurement point is ascertained,
    wherein the ascertained difference for all of the measurement points corresponds to a numerical derivative of the position travelled to.

5.  Method according to one of Claims 2 to 4,
    wherein the acquired performed movement is filtered in order to separate periodic components from nonperiodic components.

6.  Method according to Claim 5,
    wherein the acquired performed movement is filtered by subjecting the acquired performed movement to a Fourier transformation, determining associated Fourier coefficients and performing a Fourier backtransformation based on the determined Fourier coefficients.

7.  Method according to one of Claims 2 to 6,
    wherein the actuation signal according to the inverted movement function is used to actuate the drive (10) with a time-dependent actuation signal over at least one actuator period.

8.  Method according to one of the preceding claims,

    wherein the actuator (20) has a multiplicity of actuator units (50);
    wherein each actuator unit (50) has at least two actuator elements (52, 54);
    wherein a multiphase signal with one phase for each actuator element (50) is generated as actuation signal.

9.  Method according to Claim 8,
    wherein the multiphase signal is configured such that a periodic movement of the actuator units results in a linear or rotational movement of a drive element (30) of the drive (10).

10. Method according to Claim 8 or 9,
    wherein the actuator units (50) of the multiplicity of actuator units (50) are divided into two groups and the actuator units in a group are each actuated synchronously with the same phases.

**11.** Method according to one of Claims 8 to 10,
wherein each actuator unit (50) is a piezo unit with at least two piezo elements, wherein the piezo elements are connected to one another in such a way that the piezo unit is able to perform a two-dimensional movement.

**12.** Method according to one of the preceding claims,
wherein a unipolar voltage source is used to generate the actuation signal.

**13.** Method according to one of the preceding claims,
wherein the method is used to set a position of a feedback-free drive.

**14.** Control unit (40) for controlling a drive (10) having an actuator (20) with periodic irregularity, wherein the control unit (40) is designed to:

receive a movement pattern of the drive, wherein the movement pattern contains a position travelled to and an associated actuation signal of the drive;
ascertain a movement function of the drive based on the movement pattern, wherein the movement function represents the position travelled to over the associated drive signal;
invert the movement function of the drive to obtain an inverted movement function, wherein the inverted movement function represents the drive signal over the position travelled to;
actuate the drive according to the inverted movement function, wherein an actuation signal for travelling to a predefined position to be travelled to is derived from the inverted movement function.

**15.** Control unit (40) according to Claim 14,
wherein the control unit (40) is designed to:

actuate the drive (10) with a time-dependent actuation signal over at least one actuator period;
acquire a movement performed by the drive on the basis of the time-dependent actuation signal;
create the movement pattern of the drive based on the time-dependent actuation signal and the performed movement.

**Revendications**

**1.** Procédé pour commander un mécanisme d'entraînement (10) comprenant un actionneur (20) à fonctionnement périodiquement non synchrone, le procédé comprenant les étapes suivantes :

réception d'un modèle de mouvement du mécanisme d'entraînement, le modèle de mouvement présentant un mouvement accompli et un signal de commande associé du mécanisme d'entraînement ;
détermination d'une fonction de mouvement du mécanisme d'entraînement sur la base du modèle de mouvement, la fonction de mouvement représentant le mouvement accompli en fonction du signal de commande associé ;
inversion de la fonction de mouvement du mécanisme d'entraînement afin d'obtenir une fonction de mouvement inversée, la fonction de mouvement inversée représentant le signal de commande en fonction du mouvement accompli ;
commande du mécanisme d'entraînement conformément à la fonction de mouvement inversée, un signal de commande destiné à accomplir un mouvement prédéfini étant prélevé de la fonction de mouvement inversée.

**2.** Procédé selon la revendication 1, comprenant en outre les étapes suivantes :

commande du mécanisme d'entraînement (10) avec un signal de commande dépendant du temps sur au moins une période d'actionneur ;
détection d'un mouvement accompli par le mécanisme d'entraînement en fonction du signal de commande dépendant du temps ;
création d'un modèle de mouvement du mécanisme d'entraînement sur la base du signal de commande dépendant du temps et du mouvement accompli.

**3.** Procédé selon la revendication 2, le mouvement accompli par le mécanisme d'entraînement en fonction du signal de commande dépendant du temps étant détecté à des valeurs équidistantes du signal de commande et plusieurs fois pour chaque période d'actionneur.

**4.** Procédé selon la revendication 3,

la détection d'un mouvement accompli par le mécanisme d'entraînement contenant la détection d'une position gagnée par le mécanisme d'entraînement ;
pour la position gagnée, une différence par rapport à la position gagnée du point de mesure directement précédent étant déterminée pour chaque point de mesure discret, la différence déterminée correspondant à une dérivée numérique de la position gagnée pour l'ensemble des points de mesure.

**5.** Procédé selon l'une des revendications 2 à 4, le mouvement accompli détecté étant filtré afin de séparer les parts périodiques des parts non périodiques.

**6.** Procédé selon la revendication 5, le mouvement accompli détecté étant filtré en soumettant le mouvement accompli détecté à une transformée de Fourier, en déterminant les coefficients de Fourier associés et, en se basant sur les coefficients de Fourier déterminés, en effectuant une transformée de Fourier inverse.

**7.** Procédé selon l'une des revendications 2 à 6, le signal de commande étant utilisé conformément à la fonction de mouvement inversée pour commander le mécanisme d'entraînement (10) avec un signal de commande dépendante du temps sur au moins une période d'actionneur.

**8.** Procédé selon l'une des revendications précédentes,

l'actionneur (20) possédant une pluralité d'unités d'actionneur (50) ;
chaque unité d'actionneur (50) possédant au moins deux éléments actionneurs (52, 54) ;
le signal de commande généré étant un signal multiphasé avec une phase pour chaque élément actionneur (50).

**9.** Procédé selon la revendication 8, le signal multiphasé étant configuré de telle sorte qu'un mouvement périodique des unités d'actionneur résulte en un mouvement linéaire ou rotatif d'un élément d'entraînement (30) du mécanisme d'entraînement (10).

**10.** Procédé selon la revendication 8 ou 9, les unités d'actionneur (50) de la pluralité d'unités d'actionneur (50) étant subdivisées en deux groupes et les unités d'actionneur d'un groupe étant respectivement commandées de manière synchrone avec des mêmes phases.

**11.** Procédé selon l'une des revendications 8 à 10, chaque unité d'actionneur (50) étant une unité piézoélectrique avec au moins deux éléments piézoélectriques, les éléments piézoélectriques étant reliés ensemble de telle sorte que l'unité piézoélectrique peut accomplir un mouvement bidimensionnel.

**12.** Procédé selon l'une des revendications précédentes, une source de tension unipolaire étant utilisée pour générer le signal de commande.

**13.** Procédé selon l'une des revendications précédentes, le procédé étant utilisé pour régler une position d'un mécanisme d'entraînement sans rétroaction.

**14.** Unité de commande (40) pour commander un mécanisme d'entraînement (10) comprenant un actionneur (20) à fonctionnement périodiquement non synchrone, l'unité de commande (40) étant réalisée pour :

recevoir un modèle de mouvement du mécanisme d'entraînement, le modèle de mouvement présentant une position gagnée et un signal de commande associé du mécanisme d'entraînement ;
déterminer une fonction de mouvement du mécanisme d'entraînement sur la base du modèle de mouvement, la fonction de mouvement représentant la position gagnée en fonction du signal de commande associé ;
inverser la fonction de mouvement du mécanisme d'entraînement afin d'obtenir une fonction de mouvement inversée, la fonction de mouvement inversée représentant le signal de commande en fonction de la position gagnée ;
commander le mécanisme d'entraînement conformément à la fonction de mouvement inversée, un signal de commande destiné à gagner une position à gagner prédéfinie étant prélevé de la fonction de mouvement inversée.

**15.** Unité de commande (40) selon la revendication 14, l'unité de commande (40) étant réalisée pour :

commander le mécanisme d'entraînement (10) avec un signal de commande dépendant du temps sur au moins une période d'actionneur ;
détecter un mouvement accompli par le mécanisme d'entraînement en fonction du signal de commande dépendant du temps ;
créer un modèle de mouvement du mécanisme d'entraînement sur la base du signal de commande dépendant du temps et du mouvement accompli.

Fig. 1

Fig. 2A

Fig. 2B

Fig. 2C

Fig. 3A

Fig. 3B

Fig. 4

Fig. 5

Fig. 6

Fig. 7

Fig. 8A

Fig. 8B

100

110

120

130

140

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1267478 B1
- EP 2209202 B1
- EP 1737113 A
- US 20120019185 A1